# EUROPÄISCHE PATENTSCHRIFT

(11) **EP 2 136 402 B1**
(45) Veröffentlichungstag und Bekanntmachung des Hinweises auf die Patenterteilung: **15.05.2013**
(21) Anmeldenummer: 08011108.1
(22) Anmeldetag: 19.06.2008
(51) Int. Cl.: H01L 23/58, G01D 1/18

(54) **Schaltungsanordnung und Verfahren zum Programmieren eines Hallsensors mit vorgeschaltetem Controller**
Switching device and method for programming a hall sensor with pre-switched controller
Circuit et procédé de programmation d'un capteur Hall doté d'un contrôleur série

(43) Veröffentlichungstag der Anmeldung: 23.12.2009
(73) Patentinhaber: Micronas GmbH, 79108 Freiburg (DE)
(72) Erfinder: De Rosa, Adriano, 79410 Badenweiler (DE); Bagnuoli, Gualtiero, 10137 Torino (IT)
(74) Vertreter: Koch Müller Patentanwaltsgesellschaft mbH

(56) Entgegenhaltungen:
- DE-A1-102006 022 283
- DE-C1- 19 819 265
- DE-C1- 19 912 446
- INFINEON TECHNOLOGIES AG: "TLE4998S4 - Programmable Linear Hall Sensor" TARGET DATA SHEET INFINEON, INFINEON TECHNOLOGIES AG, NEUBIBERG (DE), [Online] Nr. v 0.1, 1. Januar 2007 (2007-01-01), Seiten 1-34, XP002493681 Gefunden im Internet: URL:http://www.infineon.com/dgdl/TLE4998S4 _Target_Data_Sheet_V0_1.pdf?fol derId=db3a304412b407950112b408e8c90004&fil eId=db3a304412b407950112b40 8ec480009&location=Search.TLE4998S4_Target _Data_Sheet_V0_1.pdf> [gefunden am 2007-01-31]
- "HAL805 Programmable Linear Hall Effect Sensor (Doc. No. 6251-513-1PD)" DATA SHEET, [Online] 2. Februar 2000 (2000-02-02), XP007907198 Gefunden im Internet: URL:http://www.datasheetcatalog.org/datash eet/MicronasIntermetall/mXrtyrv.pd>

## Beschreibung

Die Erfindung bezieht sich auf eine Schaltungsanordnung zum Programmieren eines Hallsensors mit vorgeschaltetem Controller mit den oberbegrifflichen Merkmalen gemäß Patentanspruch 1 bzw. auf ein Verfahren zum Programmieren eines Hallsensors mit vorgeschaltetem Controller mit den oberbegrifflichen Merkmalen gemäß Patentanspruch 8.

Allgemein bekannt ist der Einsatz von Hallsensoren mit einem vorgeschalteten Controller aus dem Bereich der Kraftfahrzeugtechnik. Dort werden Hallsensoren beispielsweise eingesetzt, um eine Batteriespannung einer Kraftfahrzeugbatterie zu überwachen. Dazu wird der eigentliche Hallsensor direkt am Batterieanschluss oder einer Batterieleitung angeordnet. Zur Auswertung dient dabei ein Controller in Form einer Steuereinheit. Dieser wird als eine separate elektronische Steuerschaltung bereitgestellt.

Üblicherweise wird der Hallsensor, welcher eine integrierte Schaltungskomponente in Form z. B. eines EPROM aufweist, um eine gewünschte Kennlinie zu programmieren, vor dem Einsatz bzw. gegebenenfalls sogar vor einer Auslieferung nach seiner Fertigung mittels einer externen Hallsensor-Programmier-Steuereinrichtung programmiert. Dazu wird die Hallsensor-Programmier-Steuereinrichtung an zumindest einen der üblicherweise drei Kontaktanschlüsse des Hallsensors angeschlossen. Die Programmierung erfolgt dadurch, dass an einen Hallsensor-Versorgungsspannungsanschluss anstelle einer Versorgungsspannung eine getaktete Spannung angelegt wird. Mittels eines solchen getakteten oder gegebenenfalls modulierten Signals wird die Schaltungskomponente programmiert. Sobald eine gewünschte Kennlinie erreicht ist, kann über einen Hallsensor-Ausgangsanschluss ein entsprechendes Steuersignal an die Hallsensor-Programmier-Steuereinrichtung ausgegeben werden, um die Beendigung der Programmierung zu signalisieren. Als dritter Kontaktstift weisen der Hallsensor und die Hallsensor-Programmier-Steuereinrichtung üblicherweise einen Masse -bzw. Basisanschluss auf.

Insbesondere die getrennte Bereitstellung des Hallsensors und des Controllers zur Ansteuerung des Hallsensors in der Endanwendung bietet somit den Vorteil, dass der Hallsensor mit seinen Anschlusskontakten zugreifbar ist, um diesen zu programmieren. Eine solche Anordnung hat jedoch auch Nachteile, wie beispielsweise die entsprechend größere Anzahl von Komponenten, welche einzubauen sind, sowie die Fehleranfälligkeit im späteren Betrieb.

Aus der DE 102006 02283 A1, der DE 19912 446 C1 und der DE 198 19 265 C1 sind Hallsensoren und Ansteuerschaltungen offenbart. Des Weiteren sind aus "INFINEON TECHNOLOGIES AG: "TLE4998S4-Programmable Linear Hall Sensor" TARGET DATA SHEET INFINEON TECHNOLOGIES AG, NEUBIBERG (DE), [ONLINE] Nr. 0.1,1. Januar 2007, Seiten 1-34, und aus "HAL805 Programmable Linear HallEffect Sensor (Doc. No. 6251-513-1PD)" DATA SHEET, [ONLINE] 2. Februar 2000 weitere integrierte Hallsensoren bekannt.

Die Aufgabe der Erfindung besteht darin, einen Hallsensor programmieren zu können, welcher zusammen mit einem vorgeschalteten Controller in einem Gehäuse integriert ist, ohne dabei eine direkte Zugriffsverbindung zu Kontaktstiften des Hallsensors zu benötigen, um diesen zu programmieren.

Diese Aufgabe wird durch eine Schaltungsanordnung zum Programmieren eines Hallsensors mit vorgeschaltetem Controller mit den Merkmalen gemäß Patentanspruch 1 bzw. durch ein Verfahren zum Programmieren eines Hallsensors mit vorgeschaltetem Controller mit den Merkmalen gemäß Patentanspruch 8 gelöst. Vorteilhafte Ausgestaltungen sind Gegenstand von abhängigen Ansprüchen.

Bevorzugt wird insbesondere eine Schaltungsanordnung zum Programmieren eines Hallsensors mit vorgeschaltetem Controller, bei der der Hallsensor einen Hallsensor-Versorgungsspannungsanschluss zum Anlegen einer Hallsensor-Versorgungsspannung aufweist, der Hallsensor einen Hallsensor-Ausgangsanschluss zum Ausgeben von Messwerten oder einer Messspannung aufweist und der Hallsensor eine in diesem integrierte programmierbare Schaltungskomponente aufweist, wobei die Schaltungskomponente mittels einer Taktung oder Modulation der Hallsensor-Versorgungsspannung programmierbar ist. Diese ist dadurch vorteilhaft, dass der Hallsensor und der diesem vorgeschaltete Controller gemeinsam in einem Gehäuse aufgenommen sind, der Controller einen Controller-Versorgungsspannungsanschluss zum Anlegen einer Controller-Versorgungsspannung aufweist, der Controller einen internen Ausgangsanschluss aufweist, dessen Pegel zu der am Controller-Versorgungsspannungsanschluss anliegenden Controller-Versorgungsspannung proportional oder gleich ist, und der interne Ausgangsanschluss an den Hallsensor-Versorgungsspannungsanschluss geschaltet oder schaltbar ist zum Anlegen des Pegel vom Controller-Versorgungsspannungsanschluss als der Taktung oder Modulation der Hallsensor-Versorgungsspannung zum Programmieren der Schaltungskomponente.

Der Controller kann einen internen Spannungsausgang aufweisen, welcher an den Hallsensor-Versorgungsspannungsanschluss geschaltet ist und die Hallsensor-Versorgungsspannung ungleich, insbesondere niedriger der Controller-Versorgungsspannung ausgibt. Dadurch kann eine ausreichend hohe Versorgungsspannung an den Controller gelegt werden, um diesen auch regulär zu betreiben. Außerdem ist an den Hallsensor eine trotzdem auch für diesen ausreichend hohe getaktete Versorungsspannung anlegbar. Dabei sind bevorzugt der interne Spannungsausgang und der interne Ausgangsanschluss zwei verschiedene Ausgangsanschlüsse des Controllers, wobei der interne Ausgangsanschluss deaktivierbar oder hochohmig schaltbar ist. Dies ermöglicht eine Abschaltung des internen Ausgangsanschlusses, wenn die Programmierung abgeschlossen ist, so dass nachfolgend eine konstant haltbare Versorgungsspannung über den internen Spannungsausgang vom Controller an den Hallsensor anlegbar ist. Ein Anschluss dient somit zum Versorgen des Hallsensors mit einer konstanten Versorgungsspannung, der andere Anschluss dient zum Anlegen der getakteten Spannung an den Hallsensor ohne dabei innerhalb des Controllers eine spezielle Vorkehrung treffen zu müssen, um mal eine konstante und mal eine getaktete Hallsensor-Versorgungsspannung ausgeben zu können.

Der Controller kann einen internen Steuersignal-Eingangsanschluss aufweisen, an den der Hallsensor-Ausgangsanschluss zum Anlegen eines ein Programmierende signalisierendes Steuersignals geschaltet ist.

Dabei wird gemäß einer Variante bevorzugt, wenn der interne Steuersignal-Eingangsanschluss direkt oder indirekt mit einem Controller-Busanschluss geschaltet ist zum Weiterleiten des Steuersignals oder eines daraus abgeleiteten Steuersignals an eine extern des Gehäuses angeordnete Hallsensor-Programmier-Steuereinrichtung. Alternativ oder kombiniert kann der interne Steuersignal-Eingangsanschluss an eine Logik des Controllers geschaltet sein, welche zum Deaktivieren der Programmierung geschaltet oder programmiert ist.

Der interne Steuersignal-Eingangsanschluss ist bevorzugt an eine Logik des Controllers geschaltet und die Logik oder eine/die extern des Gehäuses angeordnete Hallsensor-Programmier-Steuereinrichtung ist geschaltet oder programmiert, zum Deaktivieren des internen Ausgangsanschlusses und/oder des internen Steuersignal-Eingangsanschlusses nach dem Anlegen des Steuersignals. Dies ermöglicht insbesondere für den Fall, dass der interne Eingangssanschluss unabhängig von einem Messsignaleingang ist, eine Abschaltung des internen Ausgangsanschlusses, wenn die Programmierung abgeschlossen ist, so dass nachfolgend eintreffende Messdaten oder Messsignale an eine externe Schaltung anlegbar oder intern im Controller auswertbar sind, ohne dabei Logikkomponenten zur Steuerung der Programmierung des Hallsensors anzusteuern.

Außerdem wird bevorzugt ein Verfahren zum Programmieren eines Hallsensors mit vorgeschaltetem Controller, bei dem der Hallsensor oder eine in diesem integrierte programmierbare Schaltungskomponente mittels einer Taktung oder Modulation einer Hallsensor-Versorgungsspannung programmiert wird, wobei eine Controller-Versorgungsspannung getaktet oder moduliert an den Controller angelegt wird und von dem Controller abhängig von der getakteten oder modulierten Controller-Versorgungsspannung eine dementsprechend getaktete oder modulierte Hallsensor-Versorgungsspannung an den Hallsensor angelegt wird.

Nach dem Beenden der Programmierung wird die Hallsensor-Versorgungsspannung vorzugsweise mit einem konstanten Spannungswert vom Controller an den Hallsensor angelegt. An den Controller kann die Controller-Versorgungsspannung mit einem anderen Spannungswert angelegt werden, als die getaktete oder modulierte Hallsensor-Versorgungsspannung, welche mit einem insbesondere demgegenüber niedrigeren Spannungswert vom Controller an den Hallsensor angelegt wird.

Nach Abschluss der Programmierung werden interne Anschlüsse des Controllers zum Programmieren des Hallsensors bevorzugt auf einen hochohmigen Wert geschaltet oder deaktiviert.

Das Ende der Programmierung kann vom Hallsensor an den Controller signalisiert werden. Das Steuersignal zum Signalisieren des Endes der Programmierung über den Controller kann dazu an eine externe Hallsensor-Programmier-Steuereinrichtung weitergeleitet werden. Die Programmierung kann insbesondere mittels einer Hallsensor-Programmier-Steuereinrichtung durchgeführt werden, welche als externe Einrichtung an den Controller geschaltet wird.

Insbesondere kann ein solches Verfahren zum Programmieren einer derartigen Schaltungsanordnung verwendet werden.

Vorteilhaft einsetzbar ist somit eine Steuereinrichtung, insbesondere eine Kfz-Hochspannungs-Steuereinrichtung in Form des Controllers zugleich als Schnittstelle zu einem Hallsensor, welcher in einem gemeinsamen Gehäuse mit der Steuereinrichtung aufgenommen ist. Durch die Anordnung bzw. eine entsprechende Verfahrensweise wird somit eine Programmierung innerhalb der Schaltung während der Herstellung ermöglicht, ohne auf die Anschlusskontakte des eigentlichen Hallsensors unmittelbar zugreifen zu müssen.

Insbesondere einsetzbar ist dabei auch ein Steuergerät, welcher selber nur drei Controller-Anschlusskontakte aufweist, einen ersten Anschlusskontakt zum Anlegen einer Controller-Versorgungsspannung, einen zweiten Anschlusskontakt zum Anschließen eines Busses, insbesondere LIN-Busses (LIN: Local Interconnect Network), und einen dritten Anschlusskontakt für den Masse- bzw. Basisanschluss. Durch das Anlegen eines getakteten und/oder modulierten Versorgungsspannungssignals als der Controller-Versorgungsspannung an den Controller wird bei entsprechend geeigneter Ausgestaltung und/oder Programmierung des Controllers bewirkt, dass dieser als eine Schnittstelle für die Programmierung des daran angeschlossenen Hallsensors dient.

Nach Beendigung der Programmierung, welche insbesondere durch Ausgabe eines entsprechenden Steuersignals vom Hallsensor an den Controller signalisiert werden kann, beendet entweder eine entsprechende Logik im Controller selber oder bei Durchleitung des Steuersignals an die Hallsensor-Programmier-Steuereinrichtung letztere den Programmiervorgang, so dass nachfolgend der Controller in den eigentlichen Betrieb als Steuer- bzw. Auswerteschaltung für den angeschlossenen Hallsensor einsetzbar ist.

Ein Ausführungsbeispiel wird nachfolgend anhand der Zeichnung näher erläutert. Es zeigt:

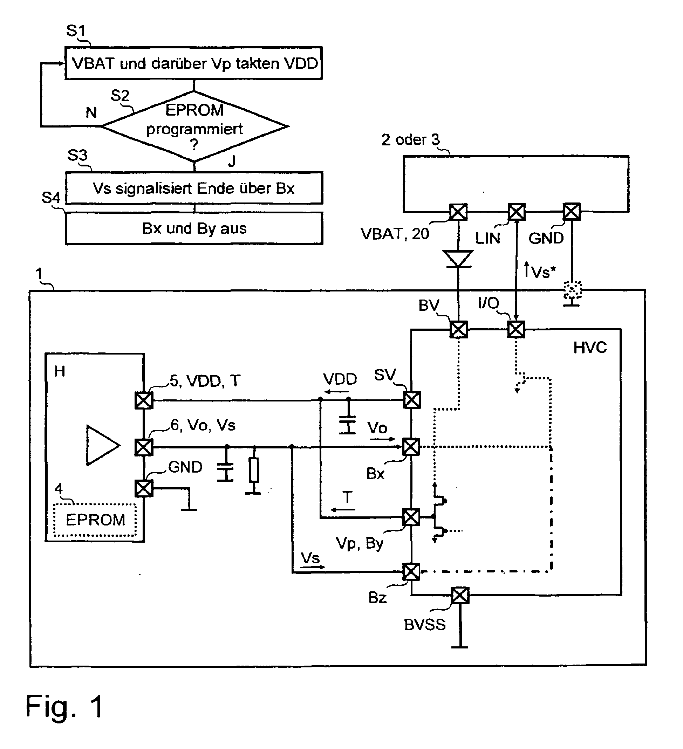

Fig. 1 eine beispielhafte Schaltungsanordnung für einen Hallsensor und einen Controller, welche integriert in einem gemeinsamen Gehäuse angeordnet sind, sowie eine Hallsensor-Programmier-Steuereinrichtung bzw. im späteren Betrieb eine Batterie oder Steuereinrichtung zum Betreiben der Schaltungsanordnung, sowie ein Ablaufdiagramm zur Veranschaulichung eines Verfahrensablaufs zum Programmieren des Hallsensors.

Wie aus Fig. 1 ersichtlich, sind in einem Gehäuse 1 ein Hallsensor H und ein Controller HVC aufgenommen. Vorzugsweise weist das Gehäuse 1 nur drei Kontaktstifte auf, welche von außen zugreifbar sind.

Die Kontaktstifte dienen dazu, über einen ersten Anschlusskontakt als einem Versorgungsspannungsanschluss BV eine Controller-Versorgungsspannung VBAT anzulegen. Die Controller-Versorgungsspannung VBAT wird vorzugsweise von einer Batterie 3 wie eine Kraftfahrzeugbatterie bereitgestellt. Gegebenenfalls kann auch eine Steuereinrichtung zwischen eine solche Batterie 3 und den Versorgungsspannungsanschluss BV geschaltet sein. Ein zweiter Anschlusskontakt dient als ein Controller-Busanschluss zum Anschließen eines Busses, insbesondere eines LIN-Busses (LIN: Local Interconnect Network), um Daten in vorzugsweise beiden Richtungen zwischen dem Controller HVC und einer externen Steuereinrichtung zu übertragen. Der dritte Anschlusskontakt dient als Masse- bzw. Basisanschluss GND.

Der Hallsensor H besteht in für sich bekannter Art und Weise aus mehreren innerhalb eines Gehäuses integrierten Komponenten. Dies sind insbesondere ein Hallelement, welches zum Erfassen eines elektrischen Stromflusses bzw. eines magnetischen Feldes geschaltet ist. Außerdem umfasst ein solcher Hallsensor H eine oder mehrere Schaltungskomponenten 4, insbesondere ein EPROM, welche zur Programmierung bzw. Kalibrierung des Hallelements bzw. zur Anpassung von dessen Messwerten dienen. Nach außen hin weist der Hallsensor H drei Anschlusskontakte auf, einen ersten Hallsensor-Versorgungsspannungsanschluss 5 zum Anlegen einer Hallsensor-Versorgungsspannung, einen zweiten Anschlusskontakt als einen Hallsensor-Ausgangsanschluss 6 zum Ausgeben einer Messspannung Vo bzw. einer Abfolge von Messwerten und einen Masse- bzw. Basisanschluss GND als drittem Anschlusskontakt.

Zur Programmierung der Schaltungskomponente 4 ist diese in dem Hallsensor H so geschaltet, dass eine Programmierung durch Anlegen eines Taktes bzw. einer Taktung T der Hallsensor-Versorgungsspannung VDD an den Hallsensor-Versorgungsspannungsanschluss 5 programmiert wird. Bei Erreichen einer gewünschten Kennlinie wird zum Abschluss der Programmierung von dem Hallsensor H anstelle der Messspannung Vo ein Steuersignal Vs am Hallsensor-Ausgangsanschluss 6 angelegt.

Der Controller HVC weist üblicherweise ebenfalls eine Vielzahl von Anschlusskontakten auf. Ein Masseanschluss BVSS dient zum Anlegen des Controllers HVC an den Masse- bzw. Basisanschluss des Gehäuses 1. Der Controller-Busanschluss I/O des Gehäuses 1 dient zugleich als ein Busanschluss des Controllers HVC. Durchgeschaltet ist vom Gehäuse 1 außerdem der Versorgungsanschluss BV zum Controller HVC, um die Controller-Versorgungsspannung VBAT an den Controller HVC anzulegen.

Zur Versorgung des Hallsensors H mit der Hallsensor-Versorgungsspannung VDD weist der Controller HVC einen internen Spannungsausgang SV auf. Interne Schaltungskomponenten des Controllers HVC sind so geschaltet, dass eine Controller-Versorgungsspannung VBAT nach gegebenenfalls Spannungsumwandlung auf den Pegel der Hallsensor-Versorgungsspannung VDD zwischen dem Versorgungsspannungsanschluss BV und dem internen Spannungsausgang SV übertragen wird. Während die Controller-Versorgungsspannung VBAT vorzugsweise auf einem Spannungswert von 12 Volt mit einer für derartige Schaltungskomponenten hohen Spannung angelegt wird, wird von einem solchen Hochspannungs-Controller als dem Controller HVC an den Hallsensor H eine Hallsensor-Versorgungsspannung VDD mit vorzugsweise 5 Volt ausgegeben. Der interne Spannungsausgang SV des Controllers HVC und der Hallsensor-Versorgungsspannungsanschluss 5 sind miteinander elektrisch leitend verbunden.

Zum Übertragen der Messspannung Vo oder entsprechender Messwerte sind der Hallsensor-Ausgangsanschluss 6 und ein interner Messsignal-Eingangsanschluss Bz miteinander verbunden. Weitere nicht dargestellte interne Komponenten, insbesondere eine interne Logik des Controllers HVC, bewirken eine Umsetzung eines empfangenen Messsignals oder der empfangenen Messspannung Vo zu Daten, welche über den Controller-Busanschluss I/O auf den LIN-Bus zur Übertragung an die entfernte externe Steuereinrichtung gesetzt werden können.

Optional können die Leitungen zwischen dem internen Spannungsausgang SV und dem Hallsensor-Versorgungsspannungsanschluss 5 bzw. zwischen dem internen Messsignal-Eingangsanschluss Bz und dem Hallsensor-Ausgangsanschluss 6 mit weiteren Schaltungskomponenten, insbesondere Kondensatoren und Widerständen gegen den Masse- bzw. Basisanschluss geschaltet sein.

Bevor die Schaltungsanordnung in dem Gehäuse 1 in einen Messbetrieb genommen werden kann, erfolgt zweckmäßigerweise eine Programmierung des Hallsensors H auf eine gewünschte Kennlinie. Dazu wird ein Programmiersignal über die Controller-Versorgungsspannung VBAT an den Controller HVC angelegt. Die Signalisierung kann insbesondere durch eine Taktung oder Modulation der Controller-Versorgungsspannung VBAT durchgeführt werden. An die Anschlusskontakte des Gehäuses 1 wird dazu gegebenenfalls eine eigenständige Hallsensor-Programmier-Steuereinrichtung 2 geschaltet, sofern nicht die externe Steuereinrichtung in dem Endbenutzungsgerät bzw. in dem Kraftfahrzeug eine solche Funktion übernimmt.

Das getaktete bzw. modulierte Signal am Versorgungsspannungsanschluss BV wird an eine Transistorschaltung angelegt. Die Transistorschaltung besteht beispielsweise aus zwei komplementär geschalteten Transistoren, deren gemeinsam verschaltete Drain-Anschlüsse an einem internen Ausgangsanschluss By anliegt. Die Schaltungskomponenten bewirken, dass eine Schwankung der Controller-Versorgungsspannung VBAT entsprechend auf dem Pegel Vp des internen Ausgangsanschluss By übertragen wird. Vorzugsweise erfolgt die Übertragung dabei auf einem maximalen Spannungsniveau, welches der Hallsensor-Versorgungsspannung VDD entspricht, um eine Schädigung der im Hallsensor H integrierten Komponenten zu vermeiden. Der interne Ausgangsanschluss By ist entsprechend elektrisch leitend mit dem Hallsensor-Versorgungsspannungsanschluss 5 verschaltet. Dadurch kann eine Taktung T in für den Hallsensor H für sich bekannte Art und Weise mit dem zwischengeschalteten Controller HVC von der angelegten Controller-Versorgungsspannung VBAT an den Hallsensor-Versorgungsspannungsanschluss 5 angelegt werden.

Um das Steuersignal Vs vom Hallsensor H zur Signalisierung einer abgeschlossenen Programmierung oder gegebenenfalls von Zwischenprogrammierschritten zu übertragen, ist der Hallsensor-Ausgangsanschluss 6 vorzugsweise an einen internen Steuersignal-Eingangsanschluss Bx geschaltet. Der interne Steuersignal-Eingangsanschluss Bx steuert interne Komponenten des Controllers HVC, insbesondere eine interne Logik, so an, dass der Controller HVC ein Ende der Programmierung erkennen kann und nachfolgend die Übertragung der Taktung über den internen Ausgangsanschluss By sowie vorzugsweise auch den Empfang weiterer Steuersignale Vs über den internen Steuersignal-Eingangsanschluss Bx beendet.

Insbesondere können dazu der interne Ausgangsanschluss By und der interne Steuersignal-Eingangsanschluss Bx hochohmig geschaltet werden. Alternativ ist auch eine Umsetzung des Steuersignals Vs zu Daten möglich, welche dann wie skizziert über den LIN-Bus an die externe Hallsensor-Programmier-Steuereinrichtung 2 übertragen werden können.

Fig. 1 zeigt außerdem im Ablaufdiagramm Verfahrensschritte für die Programmierung des Hallsensors bei einer solchen integrierten Schaltungsanordnung, welche einen direkten Zugriff auf die Hallsensor-Anschlusskontakte nicht zulässt oder unerwünscht macht. In einem ersten Verfahrensschritt S1 wird die Controller-Versorgungsspannung VBAT getaktet und darüber mittels der entsprechenden Komponenten des Controllers HVC der Pegel Vp am internen Ausgangsanschluss By getaktet. Entsprechend wird darüber ein Signal an den Hallsensor H angelegt, welches der getakteten Hallsensor-Versorgungsspannung VDD in ansonsten für sich bekannter Art und Weise entspricht.

Solange der EPROM bzw. die Schaltungskomponenten 4 noch nicht endgültig programmiert sind, wird in einem zweiten Verfahrensschritt S2 zurückgesprungen zum ersten Verfahrensschritt S1.

Nach Fertigstellung der Programmierung wird in einem dritten Verfahrensschritt S3 mittels des Steuersignals Vs das Ende der Programmierung über den internen Steuersignal-Eingangsanschluss Bx signalisiert.

In einem nachfolgenden vierten Verfahrensschritt S4 werden entsprechend der interne Ausgangsanschluss By und der interne Steuersignal-Eingangsanschluss Bx ausgeschaltet bzw. deaktiviert. Optional besteht prinzipiell auch die Möglichkeit, keine weiteren Signale an diesen Ausgangsanschlüssen anzulegen bzw. abzugreifen.

Zum Beispiel nach einem Reset des Systems geht der Controller HVC in einen eigentlichen Messbetrieb über, bei welchem an den Hallsensor-Versorgungsspannungsanschluss 5 die Hallsensor-Versorgungsspannung VDD mit konstantem Spannungspegel angelegt wird. Außerdem wird die Messspannung Vo bzw. ein entsprechendes Messsignal am internen Messsignal-Eingangsanschluss Bz empfangen und zur Übertragung über den LIN-Bus an dem Controller-Busanschluss I/O entsprechend aufbereitet bereitgestellt.

Nach dem Einschalten der Schaltungsanordnung startet der Controller HVC entsprechend seine programmierte Anwendung. Vorliegend handelt es sich dabei um einen Verarbeitungsablauf für Messsignale des Hallsensors H. Die in Fig. 1 dargestellten Anschlusskontakte sind konfiguriert wie folgt:

Der Controller-Busanschluss I/O wird für eine LIN-Kommunikation verwendet. Der interne Spannungsausgang SV versorgt den Hallsensor mit vorzugsweise +5V als der Hallsensor-Versorgungsspannung VDD. Der interne Ausgangsanschluss By und der interne Steuersignal-Eingangsanschluss Bx können in drei Zustände geschaltet werden, werden aber für den normalen Anwendungsmodus beim Betreiben des Hallsensors H nicht verwendet. Der interne Steuersignal-Eingangsanschluss Bx wird als analoger Eingangsanschluss zum Empfangen der vom Sensor ausgegebenen Messspannung Vo verwendet.

Für die Sensorprogrammierung wird beispielhaft folgende Verfahrensweise durchgeführt. Während der Herstellung der kundenorientierten elektronischen Steuereinheit in Form des Gehäuses 1 mit dem integrierten Hallsensor H und dem integrierten Controller HVC wird diese Anordnung an eine Hallsensor-Programmier-Steuereinrichtung 2 geschaltet, wozu die drei Anschlusskontakte BV, I/O und GND verwendet werden. Ein bestimmtes angelegtes LIN-Telegramm bringt die Steuereinrichtung bzw. den Controller HVC in einen Modus zur Sensorprogrammierung. Nach dem Eintreten in den Programmiermodus führt der Controller HVC verschiedene Schritte durch.

So wird eine eventuell noch bestehende LIN-Operation beendet und der Controller-Busanschluss I/O wird als einfacher Ausgang mit offenem Drain geschaltet. Außerdem wird der interne Spannungsausgang SV ausgeschaltet, so dass die Hallsensor-Versorgungsspannung VDD nicht mehr ausgegeben wird. Nachfolgend wird der interne Steuersignal-Eingangsanschluss Bx als digitaler Eingang geschaltet und zum Empfangen der Antworten des Sensors bzw. von dessen Steuersignal Vs geschaltet und verwendet. Eine spezielle Software, die in dem Controller HVC läuft oder eine entsprechende hardwaretechnische Verschaltung leiten die Eingangswerte von dem internen Steuersignal-Eingangsanschluss Bx zum Controller-Busanschluss I/O zur Ausgabe über den LIN-Bus an die Hallsensor-Programmier-Steuereinrichtung 2. Der interne Ausgangsanschluss By wird in einen normalen Ausgabemodus gesetzt. Die Ausgangsspannung bzw. der Pegel Vp wird durch Änderung der Spannung der Controller-Versorgungsspannung VBAT moduliert. Dabei betragen die Spannungen, welche gemäß einer beispielhaft angeordneten Schaltung erzielt werden müssen, 5,6 V für einen beispielhaften tiefen Zustand der Versorgungsspannung VDD, 8,0 V, für einen hohen Zustand der Versorgungsspannung VDD und 12,5 V für eine Programmier-Versorgungsspannung des Controllers HVC. Der Controller HVC soll noch in der Lage sein, normal betrieben zu werden, während die Programmierung des Hallsensors H durchgeführt wird. Während der Sensorprogrammierung des Hallsensors H wird der interne Messsignal-Eingangsanschluss Bz als analoger Eingang nicht verwendet.

## Patentansprüche

1. Schaltungsanordnung zum Programmieren eines Hallsensors (H) mit vorgeschaltetem Controller (HVC), bei der
- der Hallsensor (H) einen Hallsensor-Versorgungsspannungsanschluss (5) zum Anlegen einer Hallsensor-Versorgungsspannung (VDD) aufweist,
- der Hallsensor (H) einen Hallsensor-Ausgangsanschluss (6) zum Ausgeben von Messwerten oder einer Messspannung (Vo) aufweist und
- der Hallsensor (H) eine in diesem integrierte programmierbare Schaltungskomponente (4) aufweist, wobei die Schaltungskomponente (4) mittels einer Taktung (T) oder Modulation der Hallsensor-Versorgungsspannung (VDD) programmierbar ist,
**dadurch gekennzeichnet, dass**
der Hallsensor (H) und der diesem vorgeschaltete Controller (HVC) gemeinsam In einem Gehäuse (1) aufgenommen sind,
- der Controller (HVC) einen Controller-Versorgungsspannungsanschluss (BV) zum Anlegen einer Controller-Versorgungsspannung (VBAT) aufweist,
- der Controller (HVC) einen internen Ausgangsanschluss (By) aufweist, dessen Pegel (Vp) zu der am Controller-Versorgungsspannungsanschluss (BV) anliegenden Controllerversorgungsspannung (VBAT) proportional oder gleich ist, und
- der Interne Ausgangsanschluss (By) an den Hallsensor-Versorgungsspannungsanschluss (5) geschaltet oder schaltbar ist zum Anlegen des Pegel (Vp) vom Controller-Versorgungsspannungsanschluss (BV) als der Taktung (T) oder Modulation der Hallsensor-Versorgungsspannung (VDD) zum Programmieren der Schaltungskomponente (4).

2. Schaltungsanordnung nach Anspruch 1, bei der welcher der Controller (HVC) einen internen Spannungsausgang (SV) aufweist, welcher an den Hallsensor-Versorgungsspannungsanschluss (5) geschaltet ist und die Hallsensor-Versorgungsspannung (VDD) niedriger als die Controller-Versorgungsspannung (VBAT) ausgibt.

3. Schaltungsanordnung nach Anspruch 2, bei der welcher der interne Spannungsausgang (SV) und der interne Ausgangsanschluss (By) zwei verschiedene Ausgangsanschlüsse des Controllers (HVC) sind und der interne Ausgangsanschluss (By) deaktivierbar oder hochohmig schaltbar ist.

4. Schaltungsanordnung nach einem vorstehenden Anspruch, bei welcher der Controller (HVC) einen internen Steuersignalanschluss (Bx) aufweist, an den der Hallsensor-Ausgangsanschluss(6) zum Anlegen eines eine Programmierende signalisierendes Steuersignals (Vs) geschaltet ist.

5. Schaltungsanordnung nach Anspruch 4, bei welcher der interne Steuersignalanschluss (Bx) direkt oder indirekt mit einem Controller-Busanschluss (i/O) geschaltet ist zum Weiterleiten des Steuersignals (Vs) oder eines daraus abgeleiteten Steuersignals (Vs*) an eine externe des Gehäuses (1) angeordnete Hallsensor-Programmier-Steuereinrichtung (2).

6. Schaltungsanordnung nach Anspruch 4 oder 5, bei welcher der interne Steuersignalanschluss (Bx) an eine Logik des Controllers (HVC) geschaltet ist, welche zum Deaktivieren der Programmierung geschaltet oder programmiert ist.

7. Schaltungsanordnung nach Anspruch 4, 5 oder 6, bei welcher der interne Steuersignalanschluss (Bx) an eine Logik des Controllers (HVC) geschaltet ist und die Logik oder eine / die extern des Gehäuses (1) angeordnete Hallsensor-Programmier-Steuereinrichtung (2) geschaltet oder programmiert ist, zum Deaktivieren des internen Ausgangssignalanschlusses (By) und / oder des internen Eingangssignalsanschlusses (Bx) nach dem Anlegen des Steuersignals (Vs).

8. Verfahren zum Programmieren eines Hallsensors (H) mit vorgeschaltetem Controller (HVC), bei dem der Hallsensor (H) oder eine in diesem integrierte programmierbare Schaltungskomponente (4) mittels einer Taktung (T) oder Modulation einer Hallsensor-Versorgungsspannung (VDD) programmiert wird,
**dadurch gekennzeichnet, dass**
- eine Controller-Versorgungsspannung (VBAT) getaktet oder moduliert an den Controller (HVC) angelegt wird und,
- von dem Controller (HVC) abhängig von der getakteten oder modulierten Controller-Versorgungsspannung (VBAT) einen dementsprechend getaktete oder modulierte Hallsensor-Versorgungsspannung (VDD) an den Hallsensor (H) angelegt wird.

9. Verfahren nach Anspruch 8, bei dem nach dem Beenden der Programmierung die Hallsensor-Versorgungsspannung (VDD) mit einem konstanten Spannungswert vom Controller (HVC) an den Hallsensor (H) angelegt wird.

10. Verfahren nach Anspruch 8 oder 9, bei dem an den Controller (HVC) die Controller-Versorgungsspannung (VBAT) mit einem anderen Spannungswert angelegt wird, als die getaktete oder modulierte Hallsensor-Versorgungsspannung (VDD), welche mit einem demgegenüber niedrigeren Spannungswert vom Controller (HVC) an den Hallsensor (H) angelegt wird.

11. Verfahren nach Anspruch 8 bis 10, bei dem nach Abschluss der Programmierung interne Anschlüsse des Controllers (HVC) zum Programmieren des Hallsensors (H) auf einen hochohmigen Wert geschaltet oder deaktiviert werden.

12. Verfahren nach einem der Ansprüche 8 bis 11, bei dem das Ende der Programmierung vom Hallsensor (H) an den Controller (HVC) signalisiert wird.

13. Verfahren nach Anspruch 12, bei dem das Steuersignal zum Signalisieren des Endes der Programmierung über den Controller (HVC) an eine externe Hallsensor-Programmier-Steuereinrichtung (2) weitergeleitet wird.

14. Verfahren nach einem der Ansprüche 8 bis 13, bei dem die Programmierung mittels einer Hallsensor-Programmier-Steuereinrichtung (2) durchgeführt wird, welche als externe Einrichtung an den Controller (HVC) geschaltet wird.

15. Verfahren nach einem der Ansprüche 8 bis 14, welches zum Programmieren einer Schaltungsanordnung nach einem der Ansprüche 1 bis 7 verwendet wird.

## Claims

1. Circuit arrangement for programming a Hall sensor (H) with an upstream controller (HVC), in which
- the Hall sensor (H) has a Hall sensor supply voltage terminal (5) for application of a Hall sensor supply voltage (VDD),
- the Hall sensor (H) has a Hall sensor output terminal (6) for issue of measurement values or a measurement voltage (Vo) and
- the Hall sensor (H) comprises a programmable circuit component (4) integrated therein, wherein the circuit component (4) is programmable by means of pulsation (T) or modulation of the Hall sensor supply voltage (VDD),
**characterised in that**
the Hall sensor (H) and the controller (HVC) upstream thereof are together received in a housing (1),
- the controller (HVC) has a controller supply voltage terminal (BV) for application of a controller supply voltage (VBAT),
- the controller (HVC) has an internal output terminal (By), the level (Vp) of which is proportional to or the same as the controller supply voltage (VBAT) present at the controller supply voltage terminal (BV), and
- the internal output terminal (By) is connected or connectible with the Hall sensor supply voltage terminal (5) for applying the level (Vp) from the controller supply voltage terminal (BV) as the pulsation (T) or modulation of the Hall sensor supply voltage (VDD) for programming the circuit components (4).

2. Circuit arrangement according to claim 1, in which the controller (HVC) has an internal voltage output (SV), which is connected with the Hall sensor supply voltage terminal (5) and which issues the Hall sensor supply voltage (VDD) lower than the controller supply voltage (VBAT).

3. Circuit arrangement according to claim 2, in which the internal voltage output (SV) and the internal voltage terminal (By) are two different output terminals of the controller (HVC) and the internal output terminal (By) is deactivatable or connectible to be of high resistance.

4. Circuit arrangement according to any one of the preceding claims, in which the controller (HVC) has an internal control signal terminal (Bx), with which the Hall sensor output terminal (6) is connected for application of a control signal (Vs) signalling a program end.

5. Circuit arrangement according to claim 4, in which the internal control signal terminal (Bx) is connected directly or indirectly with a controller bus terminal (i/O) for passing on the control signal (Vs) or a control signal (Vs*) derived therefrom to a Hall sensor programming control device (2) arranged externally of the housing.

6. Circuit arrangement according to claim 4 or 5, in which the internal control signal terminal (Bx) is connected with a logic system of the controller (HVC), which is connected or programmed for deactivation of the programming.

7. Circuit arrange according to claim 4, 5 or 6, in which the internal control signal terminal (Bx) is connected with a logic system of the controller (HVC) and the logic system or a or the Hall sensor programming control device (2) arranged externally of the housing (1) is connected or programmed for deactivation of the internal output signal terminal (By) and/or of the internal input signal terminal (Bx) after application of the control signal (Vs).

8. Method of programming a Hall sensor (H) with an upstream controller (HVC), in which the Hall sensor (H) or a programmable circuit component (4) integrated therein is programmed by means of a pulsation (T) or modulation of a Hall sensor supply voltage (VDD),
**characterised in that**
- a controller supply voltage (VBAT) is applied in pulsed or modulated form to the controller (HVC) and
- depending on the pulsed or modulated control supply voltage (VBAT) a correspondingly pulsed or modulated Hall sensor supply voltage (VDD) is applied by the controller (HVC) to the Hall sensor (H).

9. Method according to claim 8, in which after the conclusion of the programming the Hall sensor supply voltage (VDD) is applied at a constant voltage value by the controller (HVC) to the Hall sensor (H).

10. Method according to claim 8 or 9, in which the controller supply voltage (VBAT) is applied to the controller (HVC) with a voltage value differing from the pulsed or modulated Hall sensor supply voltage (VDD), which is applied at a voltage value lower by comparison therewith to the Hall sensor (H) by the controller (HVC).

11. Method according to claim 8 to 10, in which, after conclusion of the of the programming, internal terminals of the controller (HVC) are, for programming the Hall sensor (H), connected to a high-resistance value or deactivated.

12. Method according to any one of claims 8 to 11, in which the end of the programming is signalled by the Hall sensor (H) to the controller (HVC).

13. Method according to claim 12, in which the control signal for signalling the end of the programming is passed on by way of the controller (HVC) to an external Hall sensor programming control device (2).

14. Method according to any one of claims 8 to 13, in which the programming is carried out by means of a Hall sensor programming control device (2) connected as an external device to the controller (HVC).

15. Method according to any one of claims 8 to 14, which is used for programming a circuit arrangement according to any one of claims 1 to 7.

## Revendications

1. Circuit de programmation d'un capteur Hall (H) doté d'un contrôleur série (HVC), dans lequel
- le capteur Hall (H) présente une borne de tension d'alimentation du capteur Hall (5) pour appliquer une tension d'alimentation du capteur Hall (VDD),
- le capteur Hall (H) présente une borne de sortie du capteur Hall (6) pour produire des valeurs de mesure ou une tension de mesure (Vo), et
- le capteur Hall (H) présente un composant de circuit programmable (4) intégré dans celui-ci, dans lequel le composant de circuit (4) peut être programmé au moyen d'une synchronisation (T) ou d'une modulation de la tension d'alimentation du capteur Hall (VDD),
**caractérisé en ce que**
- le capteur Hall (H) et le contrôleur (HVC) monté en série avant celui-ci sont logés ensemble dans un boîtier (1),
- le contrôleur (HVC) présente une borne de tension d'alimentation du contrôleur (BV) pour appliquer une tension d'alimentation du contrôleur (VBAT),
- le contrôleur (HVC) présente une borne de sortie interne (By), dont le niveau (Vp) est proportionnel ou égal à la tension d'alimentation du contrôleur (VBAT) présente à la borne de tension d'alimentation du contrôleur (BV), et
- la borne de sortie interne (By) est ou peut être connectée à la borne de tension d'alimentation du capteur Hall (5) pour appliquer le niveau (Vp) de la borne de tension d'alimentation du contrôleur (BV) comme la synchronisation (T) ou la modulation de la tension d'alimentation du capteur Hall (VDD) pour la programmation du composant de circuit (4).

2. Circuit selon la revendication 1, dans lequel le contrôleur (HVC) présente une sortie de tension interne (SV), qui est connectée à la borne de tension d'alimentation du capteur Hall (5) et qui produit la tension d'alimentation du capteur Hall (VDD) inférieure à la tension d'alimentation du contrôleur (VBAT).

3. Circuit selon la revendication 2, dans lequel la sortie de tension interne (SV) et la borne de sortie interne (By) sont des bornes de sortie différentes du contrôleur (HVC) et la borne de sortie interne (By) peut être désactivée ou connectée à haute impédance.

4. Circuit selon une revendication précédente, dans lequel le contrôleur (HVC) présente une borne de signalisation de commande interne (Bx), à laquelle la borne de sortie du capteur Hall (6) est connectée pour appliquer un signal de commande (Vs) signalant une fin de programmation.

5. Circuit selon la revendication 4, dans lequel la borne de signalisation de commande interne (Bx) est connectée directement ou indirectement à une borne de bus du contrôleur (I/O) pour la retransmission du signal de commande (Vs) ou d'un signal de commande (Vs*) dérivé de celui-ci à un dispositif de commande de programmation du capteur Hall (2) disposé à l'extérieur du boîtier (1).

6. Circuit selon la revendication 4 ou 5, dans lequel la borne de signalisation de commande interne (Bx) est connectée à une logique du contrôleur (HVC), qui est connectée ou programmée pour désactiver la programmation.

7. Circuit selon la revendication 4, 5 ou 6, dans lequel la borne de signalisation de commande interne (Bx) est connectée à une logique du contrôleur (HVC) et la logique ou un/le dispositif de commande de programmation du capteur Hall (2) disposé à l'extérieur du boîtier (1) est connecté ou programmé pour désactiver la borne de signalisation de sortie interne (By) et/ou la borne de signalisation d'entrée interne (Bx) après l'application du signal de commande (Vs).

8. Procédé de programmation d'un capteur Hall (H) doté d'un contrôleur série (HVC), dans lequel on programme le capteur Hall (H) ou un composant de circuit programmable (4) intégré dans celui-ci au moyen d'une synchronisation (T) ou d'une modulation d'une tension d'alimentation du capteur Hall (VDD),
**caractérisé en ce que**
- on applique une tension d'alimentation du contrôleur (VBAT) de façon synchronisée ou modulée au contrôleur (HVC), et
- on applique au capteur Hall (H) une tension d'alimentation du capteur Hall (VDD), synchronisée ou modulée de façon correspondante, au moyen du contrôleur (HVC) en fonction de la tension d'alimentation du contrôleur synchronisée ou modulée (VBAT).

9. Procédé selon la revendication 8, dans lequel on applique la tension d'alimentation du capteur Hall (VDD) par le contrôleur (HVC) au capteur Hall (H) avec une valeur de tension constante après la fin de la programmation.

10. Procédé selon la revendication 8 ou 9, dans lequel on applique la tension d'alimentation du contrôleur (VBAT) au contrôleur (HVC) avec une autre valeur de tension que la tension d'alimentation du capteur Hall (VDD)synchronisée ou modulée, qui est appliquée par le contrôleur (HVC) au capteur Hall (H) avec une valeur de tension inférieure à celle-ci.

11. Procédé selon une revendication 8 à 10, dans lequel, après la fin de la programmation, on connecte à haute impédance ou on désactive des bornes internes du contrôleur (HVC) pour la programmation du capteur Hall (H).

12. Procédé selon une des revendications 8 à 11, dans lequel on signale la fin de la programmation du capteur Hall (H) au contrôleur (HVC).

13. Procédé selon la revendication 12, dans lequel on retransmet le signal de commande pour signaler la fin de la programmation au moyen du contrôleur (HVC) à un dispositif extérieur de commande de programmation du capteur Hall (2).

14. Procédé selon une des revendications 8 à 13, dans lequel on effectue la programmation au moyen d'un dispositif de commande de programmation du capteur Hall (2), qui est connecté comme dispositif extérieur au contrôleur (HVC).

15. Procédé selon une des revendications 8 à 14, qui est utilisé pour la programmation d'un circuit selon une des revendications 1 à 7.
